# DEMANDE DE BREVET EUROPEEN

(11) **EP 4 757 542 A1**
(43) Date de publication de la demande: **10.06.2026**
(21) Numéro de dépôt: 25219694.4
(22) Date de dépôt: 01.12.2025
(51) Int. Cl.: H10F 30/223, H10F 71/00, H10F 77/122, H10F 77/1226

(54) **PROCEDE DE FABRICATION D'UN DISPOSITIF MICROELECTRONIQUE**

(30) Priorité: 03.12.2024 FR 2413335
(71) Demandeur: Commissariat à l'Energie Atomique et aux Energies Alternatives, 75015 Paris (FR)
(72) Inventeur: BELLEMIN COMTE, Amélie, 38054 GRENOBLE CEDEX 09 (FR); VIROT, Léopold, 38054 GRENOBLE CEDEX 09 (FR); CASTAN, Clément, 38054 GRENOBLE CEDEX 09 (FR); GARCIA, Stéphanie, 38054 GRENOBLE CEDEX 09 (FR); BAUDIN, Floriane, 38054 GRENOBLE CEDEX 09 (FR); LIMA, Gabriel, 38054 GRENOBLE CEDEX 09 (FR); STURM, Julian, 38054 GRENOBLE CEDEX 09 (FR); LAMBERT, Amélie, 38054 GRENOBLE CEDEX 09 (FR)
(74) Mandataire: Cabinet Beaumont

(57) **Abrégé**

La présente description concerne un procédé de fabrication d'un dispositif microélectronique comprenant les étapes suivantes :
a) fournir un substrat (100), une cavité (150) étant formée à partir d'une première face principale (101) du substrat (100), le fond (151) de la cavité (150) étant en un premier matériau, la première face principale (101) étant en un deuxième matériau,
b) réaliser une épitaxie sélective d'un troisième matériau dans la cavité (150), pour former une structure épitaxiée (200) remplissant et débordant de la cavité (150) d'une épaisseur dite de débordement,
c) déposer une couche d'encapsulation (300) en un quatrième matériau sur le substrat (100) et la structure épitaxiée (200),
d) réaliser une étape d'amincissement par CMP pour retirer la couche d'encapsulation (300) et la partie du matériau épitaxié dépassant de la première face principale (101),
l'épaisseur de la couche d'encapsulation (300) déposée étant comprise entre 20 et 200% de l'épaisseur de débordement.

## Description

### Domaine technique

La présente description concerne de façon générale le domaine de la microélectronique, et plus particulièrement la fabrication de dispositifs microélectroniques nécessitant la mise en œuvre d'une étape d'épitaxie sélective localisée puis une étape de planarisation.

L'invention est particulièrement intéressante pour la réalisation de photodiodes, de modulateurs à électro-absorption ou encore de lasers en Germanium, GeSn ou SiGe sur Silicium.

### Technique antérieure

Pour fabriquer certains dispositifs microélectroniques, par exemple des photodiodes, il est parfois nécessaire de faire croître sélectivement par épitaxie du germanium dans une cavité dont le fond est une souche cristalline de silicium. Pour ce faire, on dépose sur un substrat en silicium un masque en un matériau sur lequel le germanium ne croit pas. Le masque est, par exemple, en SiO₂. Des fenêtres dites de croissance ('seed window') sont formées dans le masque, par gravure, pour exposer localement la surface du silicium. Lors de l'étape de gravure, le silicium peut également être gravé afin de créer des cavités dans le substrat.

La croissance du germanium se fait alors dans des cavités. Les flancs des cavités comprennent du SiO₂ et du Si dans le cas où le substrat a été gravé.

Pour obtenir des photodiodes ayant un fonctionnement optimisé, la cavité formée doit être remplie mais le germanium ne doit pas dépasser de la cavité.

Il existe trois méthodes pour réaliser une épitaxie de silicium non débordante.

Tout d'abord, comme décrit dans la référence [1], l'épitaxie est arasante. Cependant, cette méthode n'est pas réalisable lorsque le substrat comprend des cavités de tailles et/ou profondeur différentes, car la vitesse de croissance est différente en fonction des tailles de cavités. Pour supprimer les îlots de germanium dépassant de la surface du substrat en silicium, une solution de peroxyde et d'eau peut être utilisée afin de lisser la surface de la photodiode comme décrit dans la référence [2].

Une seconde méthode consiste à réaliser une épitaxie débordante des cavités puis à mettre en œuvre une étape de planarisation, par exemple par polissage mécanochimique (CMP), pour retirer la partie du germanium qui dépasse. Pour un même dispositif comprenant des tailles de cavité différentes, le germanium peut dépasser d'une hauteur de 300 nm à plus de 1 µm. Cependant, lors de l'étape de planarisation, l'effet mécanique qui s'exerce sur ces structures génère un arrachement du germanium, ce qui créée des défauts de planarisation et le matériau épitaxié peut être détérioré [3, 4].

Une dernière méthode consiste à déposer, après l'épitaxie sélective, une fine couche d'un autre matériau (par exemple SiO₂ ou SiN) afin de protéger le germanium lors de l'étape de CMP pour éviter son altération. Cette méthode permet également de remplir les bords de cavité lorsque l'épitaxie n'est pas totalement débordante [5]. Cependant, la cavité n'est pas remplie uniquement par germanium, ce qui peut diminuer les propriétés optiques du dispositif.

### Résumé de l'invention

Il existe un besoin d'avoir un procédé de fabrication d'un dispositif microélectronique, permettant d'avoir un matériau épitaxié de bonne qualité dans une cavité.

Ce but est atteint par un procédé de fabrication d'un dispositif microélectronique, par exemple un dispositif photonique, notamment une photodiode, comprenant les étapes suivantes :
a) fournir un substrat comprenant une cavité formée à partir d'une première face principale du substrat, le fond de la cavité étant en un premier matériau, la première face principale du substrat étant en un deuxième matériau,
b) réaliser une épitaxie sélective d'un troisième matériau dans la cavité du substrat, jusqu'à ce que le matériau épitaxié remplisse la cavité et déborde de la cavité d'une épaisseur dite de débordement, moyennant quoi on obtient une structure épitaxiée,
c) déposer une couche d'encapsulation en un quatrième matériau sur le substrat et sur la structure épitaxiée,
d) réaliser une étape d'amincissement par CMP pour retirer la couche d'encapsulation et la partie de la structure épitaxiée dépassant de la première face principale du substrat, l'épaisseur de la couche d'encapsulation déposée étant comprise entre 20 et 200% de l'épaisseur de débordement.

Selon un mode de réalisation particulier, l'épaisseur de la couche d'encapsulation est comprise entre 20 et 100%, de préférence entre 20 et 50% de l'épaisseur de débordement.

Selon un mode de réalisation particulier, le fond des cavités est en un matériau semiconducteur, de préférence monocristallin, et encore plus préférentiellement en silicium monocristallin.

Selon un mode de réalisation particulier, la couche d'encapsulation est en oxyde de silicium, la couche d'encapsulation étant de préférence déposée par PECVD.

Selon un mode de réalisation particulier, le deuxième matériau est de l'oxyde de silicium.

Selon un mode de réalisation particulier, le troisième matériau est un matériau semiconducteur, de préférence du germanium ou un de ses alliages, par exemple du GeSn ou du SiGe.

Selon un mode de réalisation particulier, le substrat comprend plusieurs cavités de dimensions différentes ou identiques.

Selon un mode de réalisation particulier, les cavités ont des dimensions différentes et l'étape b) est réalisée jusqu'à ce que le matériau épitaxié déborde de toutes les cavités.

Selon un mode de réalisation particulier, une couche d'arrêt, par exemple en SiN, est disposée dans le substrat et l'étape d'amincissement est arrêtée lorsque la couche d'arrêt est atteinte.

Ce but est également atteint par un dispositif microélectronique, par exemple un dispositif photonique, comprenant un substrat, une cavité étant formée à partir d'une première face principale du substrat, le fond de la cavité étant en un premier matériau, la première face principale du substrat étant en un deuxième matériau,
la cavité étant complètement remplie par un troisième matériau semiconducteur épitaxié.

Selon un mode de réalisation particulier, le fond de la cavité est en silicium monocristallin, le deuxième matériau est en oxyde de silicium et le troisième matériau épitaxié est en SiGe, GeSn ou en Ge.

Selon un mode de réalisation particulier, le dispositif est une photodiode.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C et la figure 1D représentent, de manière schématique, différentes étapes d'un procédé de fabrication d'un dispositif microélectronique, selon un mode de réalisation particulier de l'invention ;
la figure 2A, la figure 2B, la figure 2C et la figure 2D représentent, de manière schématique, différentes étapes d'un procédé de fabrication d'un dispositif microélectronique, selon un autre mode de réalisation particulier de l'invention ;
la figure 3A, la figure 3B, la figure 3C et la figure 3D représentent, de manière schématique, différentes étapes d'un procédé de fabrication d'un dispositif photonique, selon un autre mode de réalisation particulier particuliers de l'invention ;
la figure 4 représente, de manière schématique et en coupe, un dispositif photonique, selon un autre mode de réalisation particulier particuliers de l'invention ;
la figure 5A, la figure 5B et la figure 5C sont des clichés obtenus au microscope électronique à balayage (MEB) d'un modulateur au cours de différentes étapes de son procédé de fabrication, respectivement, après épitaxie sélective de SiGe, après encapsulation avec du SiO₂ et après amincissement par CMP du SiGe et de la couche d'encapsulation en SiO₂, selon un autre mode de réalisation particulier de l'invention ;
la figure 6 est un cliché obtenu au MEB d'un modulateur après amincissement par CMP du SiGe, selon un exemple donné à titre comparatif ;
la figure 7A, la figure 7B et la figure 7C sont des clichés obtenus au MEB de différentes photodiodes sur des substrats de 300 mm après amincissement par CMP du SiGe et de la couche d'encapsulation en SiO₂, selon un autre mode de réalisation particulier de l'invention ;
la figure 8A et la figure 8B sont des clichés obtenus au MEB de différentes photodiodes sur des substrats de 200 mm après amincissement par CMP du SiGe et de la couche d'encapsulation en SiO₂, selon un autre mode de réalisation particulier de l'invention ;
la figure 9 est un cliché obtenu au MEB d'une photodiode sur un substrat 300 mm après amincissement par CMP du SiGe, selon un exemple donné à titre comparatif.

Les différents éléments ne sont pas nécessairement représentés à une échelle uniforme pour rendre les figures plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 %, de préférence à 5 %.

Par compris entre X et Y, on entend que les bornes X et Y sont incluses.

Sur les figures une seule cavité est représentée dans le substrat pour une meilleure lisibilité, mais plusieurs cavités peuvent être formées dans un même substrat.

Le procédé qui va être décrit par la suite est particulièrement intéressant pour fabriquer un dispositif microélectronique, de préférence un dispositif photonique, notamment une photodiode. Par la suite, même si la description mentionne plus particulièrement un procédé de fabrication d'une photodiode, le procédé pourrait être utilisé pour fabriquer d'autres dispositifs, par exemple, des lasers, notamment en Germanium ou SiGe intégrés sur silicium, ou des modulateurs à électro-absorption.

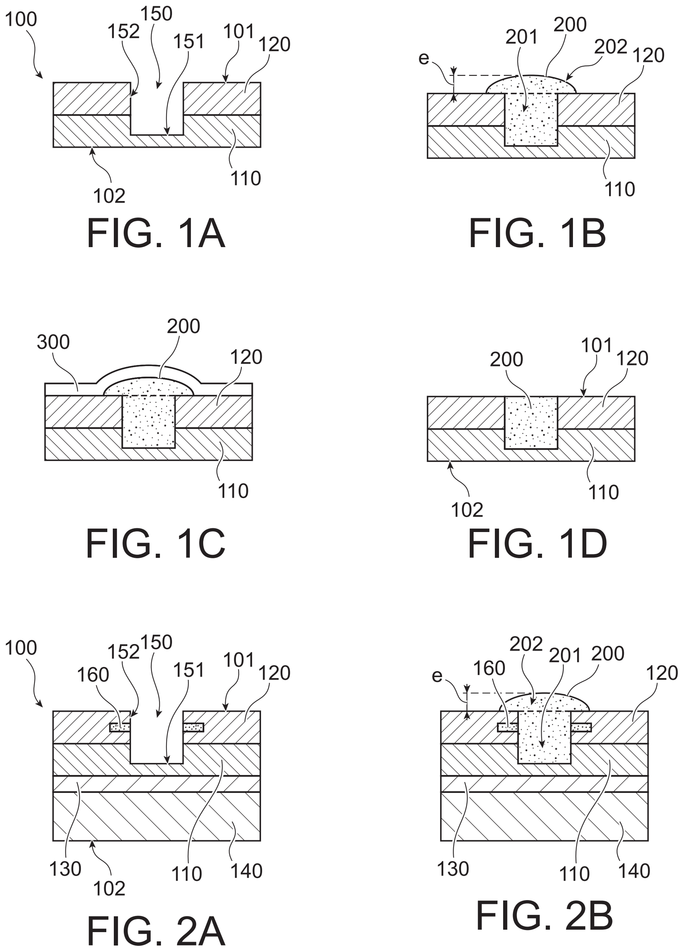

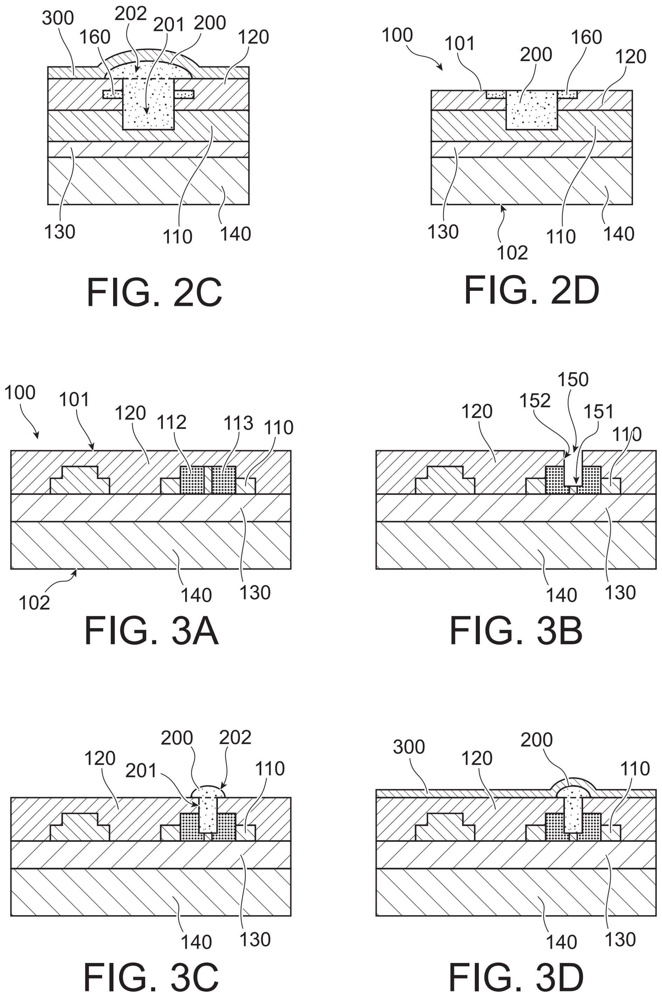

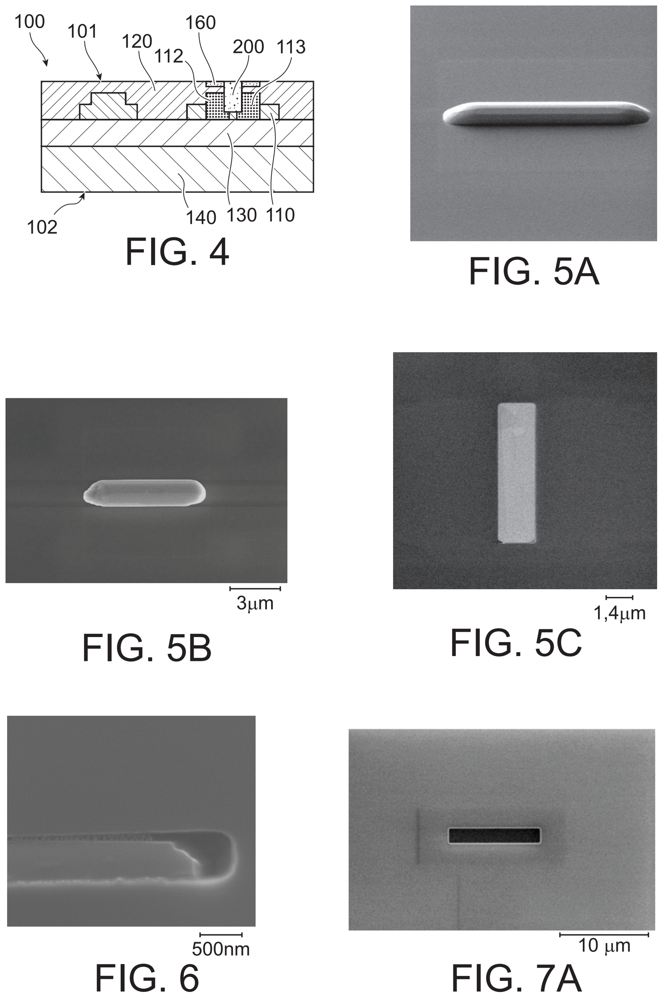

Nous allons maintenant décrire le procédé defabrication du dispositif en faisant référence aux figures 1A à 1D, aux figures 2A à 2D, aux figures 3A à 3D et à la figure 4. Le procédé comprend au moins les étapes suivantes :
a) fournir un substrat 100 comprenant une cavité 150 formée à partir d'une première face principale 101 du substrat 100, le fond 151 de la cavité 150 étant en un premier matériau, la première face 101 du substrat 100 étant en un deuxième matériau (figures 1A, 2A, 3B),
b) réaliser une épitaxie sélective d'un troisième matériau dans la cavité 150 du substrat 100, jusqu'à ce que le matériau épitaxié remplisse la cavité 150 et déborde de la cavité 150, moyennant quoi on obtient une structure épitaxiée 200 comprenant une première partie 201 remplissant la cavité 150 et une deuxième partie 202 recouvrant localement la première face principale 101 du substrat 100 au niveau du pourtour de la cavité 150 et dépassant de la première face principale 101 du substrat 100 d'une épaisseur dite de débordement (figures 1B, 2B, 3C),
c) déposer une couche d'encapsulation 300 en un quatrième matériau sur le substrat 100 et sur la structure épitaxiée 200, l'épaisseur de la couche d'encapsulation 300 déposée étant comprise entre 20 et 200%, de préférence entre 20 et 100%, et encore plus préférentiellement entre 20 et 50% (par exemple 30%), de l'épaisseur de débordement (figures 1C, 2C, 3D),
d) réaliser une étape d'amincissement par polissage mécanochimique (CMP ou 'Chemical Mechanical Polishing') pour retirer la partie 202 de la structure épitaxiée 200 dépassant de la première face principale 101 du substrat 100 (figures 1D, 2D, 3D).

Le procédé met en œuvre à la fois une étape d'encapsulation d'une structure débordante épitaxiée 200 et une étape de planarisation. Ce procédé est particulièrement avantageux.

Avec un tel procédé, il est possible de remplir des cavités 150 ayant des dimensions allant de quelques centaines de nm à plusieurs dizaines de micromètres, puisque si le matériau épitaxié déborde des cavités, il est facilement retiré, contrairement à certains procédés de l'art antérieur.

L'étape de planarisation permet d'amincir à la fois la couche d'encapsulation 300 et l'épitaxie 200 débordante à la même vitesse. L'épaisseur de la couche d'encapsulation 300 est, de préférence, moins importante que l'épaisseur de la marche à planariser. Il n'y a pas besoin de déposer une épaisseur supérieure à celle de la marche que l'on souhaite planariser car il n'est pas nécessaire d'être déjà plan au moment du début de la CMP. Ceci réduit la non uniformité de la surface après planarisation (paramètre dépendant des épaisseurs à consommer). Dans le procédé, la non-uniformité qui peut découler du procédé de CMP est minimisée puisque, même en déposant une couche d'encapsulation 300 ayant une épaisseur deux fois moins importante que la marche à planariser, les deux matériaux sont consommés à la même vitesse.

En réduisant l'épaisseur déposée, l'uniformité de l'étape de CMP est meilleure. Cela permet de diminuer l'épaisseur du matériau épitaxié au plus près du substrat.

Lors de la réalisation d'une photodiode, la croissance du germanium qui dépasse fortement de la cavité est planarisée au plus près de la hauteur du guide (environ 40 nm). Les risques d'arrachement sont supprimés grâce à l'encapsulation du matériau épitaxié. L'amincissement par CMP reste maitrisé car l'épaisseur d'encapsulation est bien plus faible que le débordement du matériau épitaxié. Cela permet d'améliorer les performances du composant.

Finalement, dans le cas d'une photodiode, il n'y a pas de facettage du troisième matériau qui serait néfaste à son fonctionnement, notamment en provoquant des pertes importantes du signal optique par réflexions sur les facettes.

Nous allons maintenant décrire plus en détail les différentes étapes du procédé.

Le substrat 100 fourni à l'étape a) comprend une première face principale 101 et une deuxième face principale 102. Au moins une cavité 150 est formée à partir de la première face principale 101 du substrat 100. Par au moins une, on entend qu'une cavité 150 ou plusieurs cavités 150 peuvent être formées à partir de la première face principale 101.

Les cavités 150 peuvent avoir des dimensions identiques ou différentes. Les dimensions des cavités 150 sont, par exemple, comprises entre quelques centaines de nanomètres à plusieurs dizaines de micromètres.

Par la suite, nous allons décrire plus particulièrement une cavité 150, mais ce qui est décrit pour ladite cavité peut s'appliquer à d'autres cavités qui seraient dans le substrat 100.

La cavité 150 comprend un fond 151 et une paroi latérale 152. Il s'agit d'un trou débouchant sur la première face principale 101 du substrat 100.

Le fond 151 de la cavité 150 est en un premier matériau configuré pour permettre le début de la croissance du troisième matériau par épitaxie. Il joue le rôle de couche de croissance ('seed layer'). Le premier matériau est, de préférence un matériau semiconducteur, encore plus préférentiellement semiconducteur cristallin, plus particulièrement monocristallin. Il s'agit, par exemple, de silicium monocristallin

La première face principale 101 du substrat 100 est en un deuxième matériau ne permettant pas la croissance du troisième matériau par épitaxie. Lors de l'étape b), le matériau épitaxié ne croît pas depuis la première face 101 du substrat 100. L'épitaxie du troisième matériau est ainsi sélective.

De préférence, au moins la partie supérieure de la paroi latérale 152 (ou flanc) de la cavité 150 est en un deuxième matériau, pour éviter la croissance du matériau épitaxié à partir du haut de la cavité 150. La partie inférieure de la paroi latérale 151 peut être faite en premier matériau. Cela favorisera le début de la croissance du matériau épitaxié depuis le bas de la cavité 150.

Par partie supérieure de la cavité 150, on entend la partie de la cavité 150 la plus proche de la première face 101. Par partie inférieure de la cavité 150, on entend la partie de la cavité 150 la plus proche du fond 151 de la cavité 150.

La partie supérieure peut être épaisse d'au moins 40 nm.

Alternativement, toute la paroi latérale 152 est en premier matériau ou en deuxième matériau.

Par exemple, dans le cas d'une épitaxie sélective en germanium ou SiGe, le fond 151 de la cavité 150 est en silicium et la première face principale 101 du substrat 100 est en oxyde de silicium. La croissance est sélective sur le silicium.

Selon un mode de réalisation particulier, par exemple représenté sur les figures 2A à 2D, 3A à 3D et 4, le substrat 100 peut être formé d'un substrat SOI ('Silicon on Insulator') recouvert d'une couche de passivation 120 en oxyde, c'est-à-dire que le substrat 100 comprend successivement un substrat support 140 en silicium, une couche d'oxyde 130 de silicium (BOX), une couche 110 de silicium monocristallin et la couche de passivation 120. La cavité 150 formée dans ce substrat 100 traverse la couche de passivation 120 et débouche dans la couche de silicium 110. La croissance démarre ainsi sur un germe de Si cristallin. La couche de passivation 120 empêche la croissance du germanium sur la première face principale 101 du substrat 100 (là où le Ge ne doit pas croître). La partie supérieure des flancs 152 de la cavité 150 sont en oxyde de silicium afin d'éviter la croissance du Ge à partir de cette partie des flancs. Les cavités 150 peuvent être formées par photolithographie.

Pour certaines applications, un guide d'onde peut être formé dans le substrat. Plus particulièrement, le guide est formé dans la couche 110 du SOI.

Selon une variante de réalisation, le substrat est formé de plusieurs couches. Une différence d'indice entre le cœur et la gaine permet de former un guide d'onde.

Comme représentée sur les figures 3A à 3D et 4, la couche de silicium 110 peut être structurée et/ou dopée. En particulier, la cavité 150 peut être positionnée entre une première partie en silicium dopée n 112 et une deuxième partie en silicium dopée p 113. La photodiode est une photodiode à double hétérojonction silicium-germanium-silicium comprenant un empilement horizontal comprenant une couche en silicium dopée n 112, une couche en germanium intrinsèque 200 et une couche en silicium dopée p 113.

Avant l'étape b) de croissance, il est possible de réaliser une étape de prétraitement. Il peut s'agir d'une étape de nettoyage (par exemple au moyen d'une solution d'acide fluorhydrique) et/ou de traitement thermique (par exemple un recuit à une température comprise entre 750 et 1000°C sous hydrogène). Le prétraitement permet d'obtenir une surface propre à la croissance.

Lors de l'étape b), le troisième matériau est épitaxié. Il peut être épitaxié par exemple par dépôt chimique en phase vapeur sous ultra-vide (ou UHV-CVD pour 'ultra-high vacuum chemical vapor deposition'). La croissance peut être réalisée à une température par exemple entre 300 et 750 °C. La température est choisie de manière à accommoder la différence de paramètre de maille entre le premier matériau et le troisième matériau sans formation d'îlots et ainsi obtenir des couches épitaxiées de bonne qualité cristalline. La croissance peut être une croissance en deux étapes à deux températures (une température basse, par exemple comprise entre 300 et 450°C, et une température haute, par exemple comprise entre 600 et 800°C). La pression est, par exemple, comprise entre 10 et 150 torr (soit entre 1333,22 et 19998,4 Pa).

La croissance n'étant pas parfaitement planaire, il est possible d'observer, lors de la croissance, différentes facettes du cristal de Ge. La croissance du matériau épitaxié est poursuivie jusqu'à le faire déborder de la cavité 150. Ceci permet d'améliorer la qualité du matériau, notamment en réduisant les dislocations dans la couche de Ge. Pour des applications optiques, et notamment, dans le cas d'une photodiode, cela permet de ne pas dégrader le couplage de la lumière par réflexions multiples.

La structure épitaxiée 200 présente une structure en forme de champignon. Une première partie 201 de la structure 200 remplit complètement la cavité 150 et une deuxième partie 202 de la structure 200 recouvre la première partie 201 et s'étend sur la première face principale 101 du substrat 100.

La partie émergeante 202 de la structure 200 a une épaisseur 'e' dite de débordement. L'épaisseur e de débordement correspond à l'épaisseur la plus grande qui est en saillie par rapport à la première face 101 du substrat 100. L'épaisseur de débordement du troisième matériau épitaxié dépend des dimensions des dispositifs. Il est nécessaire de faire une épitaxie débordante pour remplir chaque cavité. Les cavités les plus grandes sont plus longues à remplir et donc les petites cavités auront une épaisseur de débordement plus importantes. L'épaisseur de la couche d'encapsulation 300 dépend alors de la plus grande épaisseur de débordement.

La description mentionne plus particulièrement une épitaxie sélective de germanium dans des cavités ayant un fond en silicium et une couche d'encapsulation en oxyde de silicium. D'autres matériaux pourraient être utilisés à la place du germanium : par exemple un alliage de silicium, notamment du SiGe (ayant par exemple jusqu'à 30% atomique de Si) ou du GeSn (ayant par exemple jusqu'à 10% atomique de Sn. De même, d'autres associations de matériaux pourraient être utilisées, comme par exemple du silicium et de l'oxyde de silicium, du silicium polycristallin et de l'oxyde de silicium. Il est également possible d'encapsuler du cuivre par de l'oxyde de silicium, la CMP étant alors une CMP sur du SiO₂ et du cuivre. Le cuivre peut être déposé par dépôt électrochimique (ECD).

Après l'étape de croissance, une couche d'encapsulation 300 est déposée afin de recouvrir au moins la structure épitaxiée 200 et de préférence la première face principale du substrat 100 (étape c)). La couche d'encapsulation 300 est, de préférence, déposée pleine plaque.

La couche d'encapsulation 300 peut être déposée par exemple par dépôt chimique en phase vapeur assisté par plasma (PECVD).

Il s'agit d'une couche 300 jouant le rôle de couche sacrificielle. Cette couche d'encapsulation 300 réduit l'action mécanique exercée sur le matériau épitaxié et empêche les arrachements.

La couche sacrificielle 300 permet également d'adresser des débordements de différentes épaisseurs obtenus lors d'une même étape d'épitaxie pour des cavités de dimensions différentes.

La couche d'encapsulation 300 a une épaisseur comprise entre 20 et 200% de l'épaisseur de débordement.

L'épaisseur de la couche de la couche d'encapsulation 300 est, de préférence, comprise entre 20 et 100%, et encore plus préférentiellement entre 20 et 50%, et de manière très préférentielle entre 20 et 40% (par exemple environ 30%) de l'épaisseur de débordement.

La couche d'encapsulation 300 est en un quatrième matériau. Elle est, de préférence, en un même matériau que celui de la couche de passivation. Le quatrième matériau est, par exemple, du SiO₂, notamment dans le cas d'une épitaxie de germanium ou d'un de ses alliages (SiGe, GeSn).

Lors de l'étape d), une étape de CMP est ensuite mise en œuvre (étape d). Cette étape conduit à l'obtention d'une surface plane. Cette étape est non sélective. Elle permet de polir, à la fois, la couche d'encapsulation 300 déposée à l'étape c) et la structure épitaxiée 200. Les matériaux sont amincis simultanément et à la même vitesse. Il est ainsi possible de descendre, dans le cas d'une photodiode, au plus près du guide de silicium afin de limiter l'épaisseur de la photodiode. Cela permet de réduire le temps de réponse dans le cas de photodiode verticale ou latérale. Et donc réduire l'épaisseur de germanium permet d'améliorer la performance des photodiodes.

Comme représenté sur les figures 2A à 2D et sur la figure 4, le substrat 100 peut comprendre une couche d'arrêt 160. La couche d'arrêt 160 est positionnée dans un plan parallèle au fond 151 des cavités 150. Elle est disposée entre le fond 151 des cavités 150 et la première face principale 101 du substrat 100. La cavité 150 peut traverser la couche d'arrêt 160. Par exemple, dans le cas d'une photodiode, il est possible d'intégrer la couche d'arrêt 160 entre le guide d'onde et la première face principale 101 du substrat 100 afin d'améliorer l'arrêt de l'amincissement et de diminuer encore plus la non uniformité du procédé de planarisation.

Avec un tel procédé, une très bonne uniformité peut être obtenue sur de grandes surfaces, et notamment sur toute une plaque (par exemple, avec une uniformité autour de 2% sur l'épaisseur de la couche d'arrêt).

La couche d'arrêt 160 est séparée du premier matériau par une épaisseur la plus fine possible, par exemple, par une épaisseur comprise entre 10 et 20nm. La couche d'arrêt 160 pourrait être en contact avec le premier matériau.

La couche d'arrêt 160 peut être en SiN. En fonction des différents matériaux du substrat et du matériau épitaxié, il est également possible de choisir des couches d'arrêt sur SiC ou SiO₂.

A l'issue de l'étape d), le procédé peut comprendre des étapes ultérieures, par exemple des étapes d'encapsulation et/ou de formation des contacts sur la zone p 113 et la zone n 112. Ces étapes peuvent être réalisées au moyen d'étapes de gravure, de remplissage et de CMP. Plus le dispositif est aminci et plus les reprises de contact peuvent avoir de petites dimensions.

Le dispositif obtenu comprend un substrat 100 ayant une première face principale 101 et une deuxième face principale 102, une cavité 150 étant formée à partir de la première face principale 101 du substrat 100. Le fond 151 de la cavité 150 est en un premier matériau, de préférence semiconducteur. La première face principale 101 du substrat 100 est en un deuxième matériau. La cavité 150 est complètement remplie par un troisième matériau semiconducteur épitaxié 200 (autrement dit, il n'y a pas d'autres matériaux dans la cavité 150).

Le premier matériau semiconducteur et le troisième matériau semiconducteur sont, de préférence, des matériaux cristallins, encore plus préférentiellement des matériaux semiconducteurs monocristallins.

Le substrat 100 comprend, par exemple, successivement : un substrat support 140 de silicium, une couche d'oxyde 130 de silicium (« BOX »), et une couche 110 de silicium pouvant être structurée et/ou dopée et une couche de passivation 120.

Le matériau épitaxié 200 est, de préférence, du germanium, du GeSn ou du SiGe.

Le matériau épitaxié 200 peut être disposé entre une première partie en silicium dopée n (Si-) 112 et une deuxième partie en silicium dopée p (Si+) 113 pour former une photodiode PIN. Le matériau épitaxié 200 est le matériau intrinsèque dans la photodiode PIN. La photodiode est à double hétérojonction.

La zone d'absorption de la photodiode correspond au germanium épitaxié. Cette zone d'absorption est une zone configurée pour absorber en partie au moins le flux lumineux et générer des charges électriques.

La photodiode peut être couplée à un guide d'ondes. Le couplage peut être un couplage par évanescence. Par exemple, le couplage peut se faire de manière évanescente avec un guide d'onde formé dans la couche SOI 110 et le germanium qui est épitaxié par-dessus. Il est également possible d'avoir un couplage direct avec un guide d'onde formé dans la couche 110 lorsque la cavité est gravée dans la couche du SOI 110.

### Exemple illustratif et non limitatif

Dans ce premier exemple, un modulateur a été fabriqué.

Après avoir réalisé une épitaxie sélective débordante de germanium dans une cavité dont le fond est en silicium (figure 5A), le germanium a été encapsulé par une couche d'encapsulation en SiO₂ (figure 5B), puis une étape de CMP non sélective a été mise en œuvre (figure 5C).

A titre comparatif, un modulateur a été fabriqué selon les étapes suivantes : réaliser une épitaxie sélective de germanium dans des cavités de différentes tailles puis réaliser l'étape de planarisation. Dans l'exemple comparatif, il n'y a pas d'étape d'encapsulation. Le dispositif obtenu montre des marques d'arrachement (figure 6).

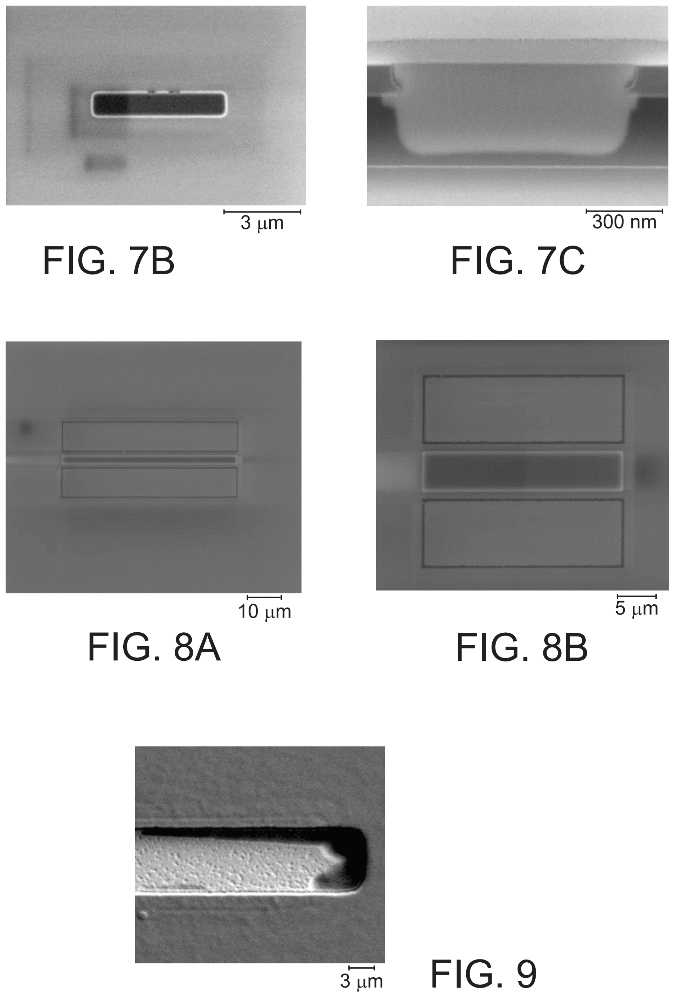

Des photodiodes ont été fabriquées sur des substrats de 300 mm (figures 7A, 7B et 7C) et de 200 mm (figures 8A et 8B). Plusieurs masques différents ont été testés. Des photodiodes allant de 300 nm de large à une centaine de microns ont pu ainsi être fabriquées.

Les observations par MEB montrent que la structure des photodiodes est exempte de défauts.

A tire comparatif, des photodiodes ont été fabriquées sans déposer de couches d'encapsulation. Après CMP, des marques d'arrachement sont visibles (figure 9).

Ceci confirme que c'est grâce à la présence de couche d'encapsulation, déposée avant la CMP, que le germanium ne présente pas de marques d'arrachement.

Les performances principales obtenues avec ce procédé sont les suivantes :
- une topographie locale après CMP inférieure à 20nm,
- une épaisseur d'oxyde après amincissement par CMP d'au moins 50 nm.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

### REFERENCES

[1] Ryzhak et al., « Selective Epitaxy of Germanium on silicon for the fabrication of CMOS compatible short-wavelength infrared photodetectors », Mater. Sci. Semicond. Process. (2024), 176, 108308
[2] US 2010/0151619 A1
[3] Bae et al., « Chemical mechanical planarization mechanism of epitaxially grown Ge-film for sequential integrating 3D-structured transistor cells », J. Korean Phys. Soc. (2022), 81, 12, 1262-1268
[4] JP 6696735 B2
[5] WO 2020/096620 A1

## Revendications

1. Procédé de fabrication d'un dispositif microélectronique, par exemple un dispositif photonique, notamment une photodiode, comprenant les étapes suivantes :
a) fournir un substrat (100) comprenant une cavité (150) formée à partir d'une première face principale (101) du substrat (100), le fond (151) de la cavité (150) étant en un premier matériau, la première face principale (101) du substrat (100) étant en un deuxième matériau,
b) réaliser une épitaxie sélective d'un troisième matériau dans la cavité (150) du substrat (100), jusqu'à ce que le matériau épitaxié remplisse la cavité et déborde de la cavité d'une épaisseur dite de débordement, moyennant quoi on obtient une structure épitaxiée (200),
c) déposer une couche d'encapsulation (300) en un quatrième matériau sur le substrat (100) et sur la structure épitaxiée (200),
d) réaliser une étape d'amincissement par CMP pour retirer la couche d'encapsulation (300) et la partie de la structure épitaxiée (200) dépassant de la première face principale (101) du substrat (100),
l'épaisseur de la couche d'encapsulation (300) déposée étant comprise entre 20 et 200% de l'épaisseur de débordement.

2. Procédé selon la revendication précédente, dans lequel l'épaisseur de la couche d'encapsulation (300) est comprise entre 20 et 100%, de préférence entre 20 et 50% de l'épaisseur de débordement.

3. Procédé selon l'une des revendications précédentes, dans lequel le fond (151) de la cavité (150) est en un matériau semiconducteur, de préférence monocristallin, et encore plus préférentiellement en silicium monocristallin.

4. Procédé selon l'une des revendications précédentes, dans lequel la couche d'encapsulation (300) est en oxyde de silicium, la couche d'encapsulation (300) étant de préférence déposée par PECVD.

5. Procédé selon l'une des revendications précédentes, dans lequel le deuxième matériau est de l'oxyde de silicium.

6. Procédé selon l'une des revendications précédentes, dans lequel le troisième matériau est un matériau semiconducteur, de préférence du germanium ou un de ses alliages, par exemple du GeSn ou du SiGe.

7. Procédé selon l'une des revendications précédentes, dans lequel le substrat (100) comprend plusieurs cavités (150) de dimensions différentes ou identiques.

8. Procédé selon la revendication précédente, dans lequel les cavités (150) ont des dimensions différentes et dans lequel l'étape b) est réalisée jusqu'à ce que le matériau épitaxié (200) déborde de toutes les cavités (150).

9. Procédé selon l'une des revendications précédentes, dans lequel une couche d'arrêt (160), par exemple en SiN, est disposée dans le substrat (100) et dans lequel l'étape d'amincissement est arrêtée lorsque la couche d'arrêt (160) est atteinte.

10. Dispositif microélectronique, par exemple un dispositif photonique, comprenant un substrat (100), une cavité (150) étant formée à partir d'une première face principale (101) du substrat (100), le fond (151) de la cavité (150) étant en un premier matériau, la première face principale (101) du substrat (100) étant en un deuxième matériau,
une partie supérieure d'une paroi latérale (152) de la cavité (150) étant en deuxième matériau et une partie inférieure de la paroi latérale (151) de la cavité (150) étant en premier matériau,
la cavité (150) étant complètement remplie par un troisième matériau semiconducteur épitaxié (200).

11. Dispositif selon la revendication 10, dans lequel le fond (151) de la cavité est en silicium monocristallin, le deuxième matériau est en oxyde de silicium et le troisième matériau épitaxié est en SiGe, GeSn ou en Ge.

12. Dispositif selon l'une des revendications 10 et 11, dans lequel le dispositif est une photodiode.
